# EUROPÄISCHE PATENTSCHRIFT

(11) **EP 0 662 219 B1**
(45) Veröffentlichungstag und Bekanntmachung des Hinweises auf die Patenterteilung: **04.09.1996**
(21) Anmeldenummer: 93912396.4
(22) Anmeldetag: 16.06.1993
(51) Int. Cl.: G01R 15/18

(54) **VERFAHREN ZUR KONTAKTLOSEN BESTIMMUNG ELEKTRISCHER MESSGRÖSSEN**
PROCESS FOR CONTACTLESSLY DETERMINING ELECTRICAL MEASUREMENTS
PROCEDE PERMETTANT DE DETERMINER SANS CONTACT DES VALEURS ELECTRIQUES DE MESURE

(43) Veröffentlichungstag der Anmeldung: 12.07.1995
(73) Patentinhaber: Winkler, Franz, A-1210 Wien (AT)
(72) Erfinder: Winkler, Franz, A-1210 Wien (AT)
(74) Vertreter: Miksovsky, Alexander, Dipl.-Ing.
(86) Internationale Anmeldenummer: AT9300102
(87) Internationale Veröffentlichungsnummer: WO9429733

(56) Entgegenhaltungen:
- AU-B- 471 986
- US-A- 4 558 310
- IBM TECHNICAL DISCLOSURE BULLETIN Bd. 10, Nr. 7, Oktober 1967, NEW YORK US Seite 876;BORNHAUSER 'AMPLIFICATION OF EXTREMELY LOW DC CURRENTS AND VOLTAGES'
- IEEE TRANSACTIONS ON MAGNETICS Bd. 26, Nr. 5, September 1990, NEW YORK US Seiten 1566 - 1568;KASHIWAGI ET AL. '300 A CURRENT SENSOR...' s

## Beschreibung

Die Erfindung bezieht sich auf ein Verfahren zur kontaktlosen Bestimmung elektrischer Meßgrößen, wie z.B. Gleichströmen, Leistungen oder Widerständen, in einem Leiter.

Für die kontaktlose Bestimmung elektrischer Meßgrößen ist es lediglich im Zusammenhang mit der Messung von Strömen bekannt geworden, elektrische Leiter mit einer Zange berührungslos abzugreifen, wobei die Zange den Leiter möglichst vollständig umgeben soll. Wenn an einem ringförmigen magnetischen Leiter, welcher den stromdurchflossenen Leiter weitestgehend vollständig umgibt, ein Spulensystem angeordnet ist, wird in einem derartigen Spulensystem eine dem Strom im elektrischen Leiter proportionale Größe induziert und auf Grund der bekannten Proportionalität des Induktionsstromes zur die Induktion bewirkenden Meßgröße, ist auf diese Weise eine berührungslose Bestimmung von Stromstärken möglich. Für die kontaktlose Bestimmung von Gleichströmen mit Hilfe solcher Stromzangen wird in dem bekannten Verfahren die Strommessung auf eine Magnetfeldmessung mit Hallsonden oder Magnetisierungskennliniensonden zurückgeführt. Diese Sonden weisen jedoch Nachteile hinsichtlich Offset, Rauschen und Temperaturfehler auf. Weiters ist es nachteilig, daß dieses Verfahren nur dann durchführbar ist, wenn der Leiter, in welchem der zu bestimmende Strom fließt, zur Gänze umgriffen werden kann.

Es ist bekannt, daß elektromagnetische Wechselfelder in Spulen Signale induzieren, welche sich in der Folge zu verschiedenen Anzeigen eignen. Eine quantitative Auswertung zur Bestimmung der Meßgröße selbst ist aber in der Regel mangels geeigneter Referenzfelder nicht ohne weiteres möglich. Aus dem IBM Technical Disclosure Bulletin, Bd. 10, Nr. 7, Dezember 1967, Seite 876 ist es bekannt geworden, ein Spulensystem in mechanische Schwingungen zu versetzen, um auf diese Weise sehr kleine Gleichströme und -spannungen zu erfassen. Aus der AU-B-471 986 schließlich ist ein Magnetometer bekannt, bei welchem ein Leiter in Schwingungen versetzt wird und das durch ein Magnetfeld induzierte Signal gemessen wird.

Die Erfindung zielt nun darauf ab, ein Verfahren der eingangs genannten Art zu schaffen, mit welchem die berührungslose bzw. kontaktlose Bestimmung von Gleich- oder Wechselströmen, Leistungen oder Widerständen selbst dann ermöglicht wird, wenn überaus kleine Meßgrößen erfaßt werden sollen und weiters darauf ab, derartige Meßgrößen exakter und reproduzierbar zu erfassen. Zur Lösung dieser Aufgabe besteht das erfindungsgemäße Verfahren im wesentlichen darin, daß wenigstens zwei in einem Abstand voneinander angeordnete Spulensysteme in das elektromagnetische Feld des Leiters positioniert werden, wobei ein elektrisch leitender Bauteil in der Nähe der Spulen dieser Spulensysteme in periodische mechanische Schwingungen versetzt wird, daß die Signale der Spulen, gegebenenfalls nach einer Korrektur ihrer Phasen, einer Subtrahierschaltung zur Bestimmung eines Spannungsgradienten zwischen diesen Spulen zugeführt werden und daß in einer Auswerteschaltung der Quotient aus dem Quadrat eines Spannungsmeßwertes und des Spannungsgradienten gebildet und einem Ausgang zugeführt wird, daß zusätzlich zu den wenigstens zwei im Abstand voneinander angeordneten Spulensystemen ein weiteres, in einem Abstand von einem Vielfachen der halben Wellenlänge des periodisch schwingenden Bauteils angeordnetes Spulensystem vorhanden ist und daß die Meßwerte von zwei um diesen Abstand versetzten Spulensystemen verglichen werden. Dadurch, daß zwei in einem Abstand voneinander angeordnete Spulensysteme zum Einsatz gelangen, wird zunächst sichergestellt, daß in den beiden voneinander verschiedenen Spulensystemen ihrem Abstand entsprechend unterschiedliche Spannungen induziert werden. Mit Rücksicht auf den bekannten Abstand zwischen den beiden Spulensystemen bzw. mit Rücksicht auf den Umstand, daß die Verschiedenheit der Meßgrößen nunmehr eine Kompensation ermöglicht, gelingt es, auf die tatsächliche zu messende Meßgröße rückzurechnen bzw. rückzuschließen.

Zur Bestimmung von Gleichströmen ist es erforderlich, für eine entsprechende Induktion Sorge zu tragen und dies gelingt dadurch, daß erfindungsgemäß ein elektrisch leitender Bauteil in der Nähe der Spulen in periodische mechanische Schwingungen versetzt wird.

Als mechanische Schwingungen können z.B. Ultraschallschwingungen verwendet werden, wobei derartige mechanische Schwingungen mit Rücksicht auf die relativ hohe Frequenz naturgemäß auch im Falle von niedrigfrequenten Wechselströmen eine Messung ermöglichen. Zwischen Gleichströmen bzw. Wechselströmen niedriger Frequenz und Wechselströmen hoher Frequenz kann jedoch unterschieden werden, indem beispielsweise der Schwingungserreger abgeschaltet wird, worauf im Falle von Gleichströmen bzw. niederfrequenten Wechselströmen ein weiteres Signal für eine Auswertung nicht mehr zur Verfügung steht.

Eine Verbesserung der Meßgenauigkeit kann dadurch erreicht werden, daß das dem Leiter abgewandte Spulensystem einem System zur Erzeugung von Referenzfeldern ausgesetzt wird, und daß die Referenzfelder so gesteuert und verändert werden, bis ein Abgleich auf Null der Meßwerte der Spulensysteme erzielt wird. Mit einer derartigen Verfahrensführung lassen sich überaus kleine Meßgrößen exakt und reproduzierbar erfassen.

Um sicherzustellen, daß die Meßwerte durch den Antrieb des mechanischen Erregers der periodischen Schwingungen nicht beeinträchtigt werden, kann mit Vorteil das erfindungsgemäße Verfahren so durchgeführt werden, daß der Erreger der mechanischen periodischen Schwingungen intermittierend betrieben wird und daß die Meßwerte der Spulensysteme in abgeschaltetem Zustand des Erregers einer Auswertung und Bearbeitung unterzogen werden.

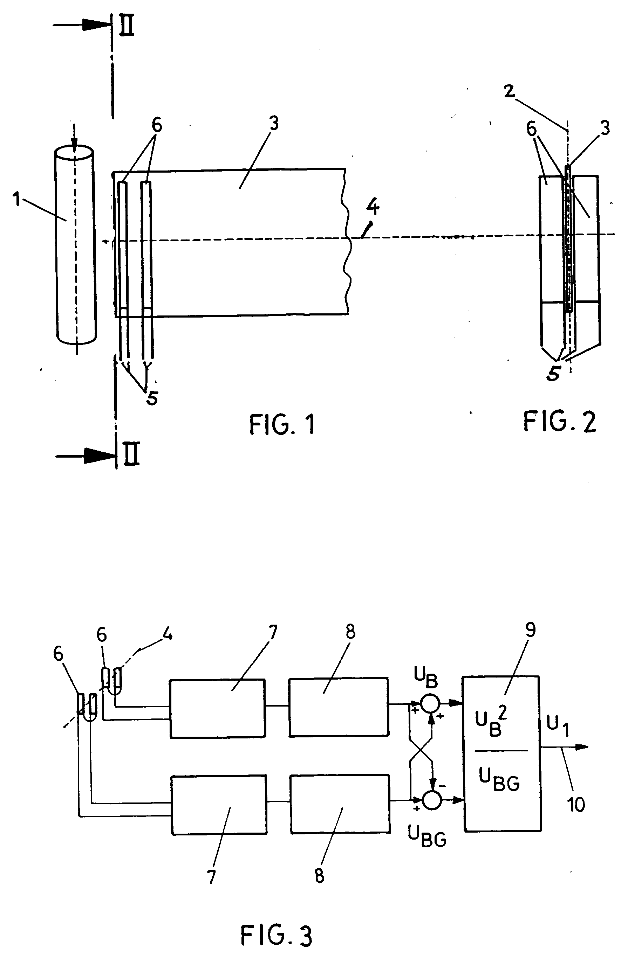

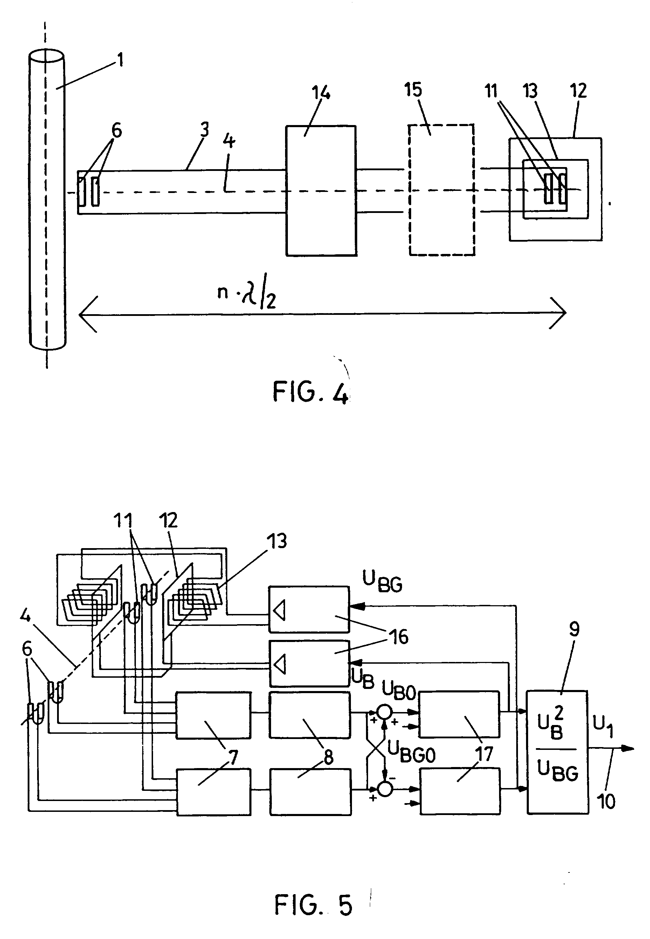

Die Erfindung wird nachfolgend an Hand von in der Zeichnung schematisch dargestellten Ausführungsbeispielen näher erläutert. In dieser zeigen Fig.1 eine schematische Darstellung; Fig.2 eine Ansicht in Richtung des Pfeiles II der Fig.1; Fig.3 schematisch ein Schaltdiagramm zur Auswertung von mit den Spulensystemen der Ausbildung gemäß Fig.1 aufgenommenen Meßgrößen; Fig.4 in einer zu Fig.1 ähnlichen Darstellung eine Ausführungsform zur Durchführung des erfindungsgemäßen Verfahrens, wobei ein Referenzspulensystem Verwendung findet; Fig.5 ein Schaltdiagramm zur Auswertung von mit der Ausführungsform gemäß Fig.4 aufgenommenen Meßgrößen.

In Fig.1 ist mit 1 ein elektrischer Leiter bezeichnet, in welchem durch eine kontaktlose Messung eine elektrische Meßgröße in Form eines Stromes bestimmt werden soll. Zur kontaktlosen Bestimmung von Gleichströmen wird in die Nähe des elektrischen Leiters ein in periodische mechanische Schwingungen versetzbarer bzw. versetzter Bauteil 3 gebracht, welcher selbst wiederum elektrisch leitend ist. Dabei ist in Fig.2 mit 2 strichliert die Mittellinie in Querrichtung des schwingenden Bauteiles 3 angedeutet. Die gestrichelte Linie 4 gibt die Mittellinie des Bauteiles 3 in Längsrichtung an.

Weiters ist vorgesehen, daß zwei in unterschiedlichem Abstand vom Leiter 1 angeordnete Spulensysteme 6 mit Anschlüssen 5 in die Nähe des Leiters 1 gebracht werden, wobei zur Bestimmung von Gleichströmen und Wechselströmen im elektrischen Leiter die Spulen 6 wiederum mit dem periodisch schwingenden Bauteil 3 zusammenwirken, indem dieser das magnetische Feld durch die Wirbelströme in diesem Bauteil verzerrt, wodurch in den Spulen 6 ein Signal induziert wird, welches nach einer Auswertung zur Bestimmung der elektrischen Meßgröße herangezogen werden kann. Die räumliche Anordnung der Spulensysteme 6 relativ zum periodisch schwingenden Bauteil 3 ist in Fig.2 näher dargestellt, wobei bei der gezeigten Ausführungsform die Spulen 6 symmetrisch relativ zum Bauteil 3 angeordnet sind, so daß insgesamt vier Spulen Verwendung finden, welche jeweils paarweise angeordnet sind. Dies trägt zu einer Erhöhung der Genauigkeit bei der Bestimmung der elektrischen Meßgröße bei. Die Anordnung von lediglich zwei Spulen in unterschiedlichem Abstand vom elektrischen Leiter 1 ist jedoch ausreichend. Bei Verwendung von Doppelspulen ist es unerheblich, ob die Signale der Teilspulen durch Verbinden der Anschlüsse in der gezeichneten Weise verknüpft werden, oder ob die Verknüpfung erst in der Auswerteschaltung 7, wie in Fig.3 gezeigt, oder später erfolgt. Bei Messung von Wechselströmen ausreichend hoher Frequenzen kann auf den schwingenden Bauteil 3 verzichtet werden, da gemäß bekannten Gesetzmäßigkeiten entsprechende Meßgrößen abgenommen werden können.

Neben der Bestimmung von Stromstärken können gemäß ebenfalls bekannten Gesetzmäßigkeiten Widerstände und Leistungen aus den gewonnenen Signalen abgeleitet werden, wobei die dazu erforderliche Spannungsmessung nach einem bekannten kontaktierenden oder kontaktlosen Verfahren zu erfolgen hat.

Bei dem in Fig.3 dargestellten schematischen Schaltkreis sind die Spulen 6 angedeutet, welche in Analogie zur Ausführungsform gemäß den Fig.1 und 2 paarweise relativ zur Mittellinie 4 des schwingenden Bauteiles 3 angeordnet sind. Die an den Spulen 6 abgenommenen Signale werden einem ersten Auswerteelement 7 zugeführt, in welchem eine Anpassung, eine Verstärkung und gegebenenfalls eine Phasenkompensation vorgenommen wird. Anschließend gelangen sie in ein Element 8 für eine Übersprechkompensation, worauf anschließend ein Wert U_{B} für die Spannung und ein zweiter Wert U_{BG} für den Gradienten der Spannung zwischen den zwei Spulen erhalten wird. Die Übersprechkompensation und die Bildung von U_{B} und U_{BG} kann auch in einem Zuge erfolgen. Es erfolgt anschließend eine Quotientenbildung 9 zwischen dem Quadrat der Spannung U_{B} und dem Gradienten U_{BG} woraus sich ein Spannungswert U₁ ergibt, welcher entsprechend dem Pfeil 10 einer Anzeige oder weiteren Auswertung zugeführt werden kann.

Dies kann dabei derart erfolgen, daß die Meßsignale drahtlos mit Funkübertragung oder mit Lichtübertragung zu einer Auswerteeinheit gesendet werden und/oder Steuersignale drahtlos von der Auswerteeinheit zum Schaltkreis übertragen werden.

Bei der Ausführungsform gemäß den Fig.4 und 5 werden für gleiche Bauteile die Bezugszeichen der vorangehenden Ausführungsform beibehalten. Zusätzlich zu den im unterschiedlichem Abstand vom Leiter 1 angeordneten Spulensystemen 6, welche wiederum bei der Bestimmung von Gleichströmen mit dem periodisch schwingenden, elektrisch leitenden Bauteil 3 zusammenwirken, ist in einem Abstand, welcher einem Vielfachen n der halben Wellenlänge des periodisch schwingenden Bauteiles 3 entspricht, ein weiteres System von Spulen 11 vorgesehen, wobei das System von Spulen 11 einem Spulensystem 12 zur Simulierung des festzustellenden Spannungswertes U_{B} und einem Spulensystem 13 zur Simulierung des zu bestimmenden Spannungsgradienten U_{BG} ausgesetzt ist, wie dies aus Fig.5 deutlich ersichtlich ist.

Der periodisch schwingende, elektrisch leitende Bauteil 3 wird bei der gezeigten Ausführungsform durch ein schematisch angedeutetes Piezoelement 14 zu seiner Schwingung angeregt, wobei das Piezoelement 14 sich in einem Knoten der Schwingung des Bauteiles 3 befindet. Alternativ zu dem Erreger 14 kann in einem Bauch der Schwingung des Bauteiles 3 ein elektromagnetischer Erreger 15 vorgesehen sein, welcher in Fig.4 strichliert angedeutet ist.

Zusätzlich zu den in Fig.3 gezeigten Komponenten des Schaltkreises sind bei der Ausführungsform gemäß Fig.5 Stromtreiber 16 vorgesehen, welche, wie oben erwähnt, zur Erzeugung eines Referenzfeldes bzw. zur Simulierung der zu bestimmenden Meßgrößen herangezogen werden. Die Signale sämtlicher Spulen bzw. Spulensysteme 6 und 11 werden wiederum den Bauteilen 7 und 8 zugeführt, woraus Signale für die Spannung U_{B0} und den Spannungsgradienten U_{BG0} Regelverstärkern 17 zugeführt werden, wobei eine Veränderung der Verhältnisse in den Referenzspulensystemen 12 und 13 über die Stromtreiber 16 so lange erfolgt, bis ein Abgleich der Meßgröße der Spulensysteme 6 und 11 auf Null erfolgt. Bei Erreichen eines derartigen Abgleiches wird wiederum im Element 9 der Quotient aus dem Quadrat der Spannung U_{B} und dem Spannungsgradienten U_{BG} gebildet, woraus sich wiederum der Spannungswert U₁ ableiten läßt, welcher einer Anzeige bzw. Auswertung über 10 zugeführt wird.

Da eine Realisierung der Schaltung als IC zweckmäßig ist, sollte berücksichtigt werden, daß die Signale bereits nach Anpassung und Verstärkung im Element 7 digitalisiert werden können und daß die weitere Signalverarbeitung, wie Phasenkompensation, Übersprechkompensation usw., durch Rechenalgorithmen realisiert werden kann. Im Falle der Fig.5 kann der Regelverstärker 17 ebenfalls durch Regelalgorithmen verwirklicht werden. Vor den Stromtreibern 16 hätte wieder eine Digital-Analog-Umsetzung zu erfolgen.

## Patentansprüche

1. Verfahren zur kontaktlosen Bestimmung elektrischer Meßgrößen in einem Leiter (1), dadurch gekennzeichnet, daß wenigstens zwei in einem Abstand voneinander angeordnete Spulensysteme in das elektromagnetische Feld des Leiters (1) positioniert werden, wobei ein elektrisch leitender Bauteil (3) in der Nähe der Spulen (6) dieser Spulensysteme in periodische mechanische Schwingungen versetzt wird, daß die Signale der Spulen (6), gegebenenfalls nach einer Korrektur ihrer Phasen, einer Subtrahierschaltung zur Bestimmung eines Spannungsgradienten zwischen diesen Spulen zugeführt werden und daß in einer Auswerteschaltung der Quotient aus dem Quadrat eines Spannungsmeßwertes und des Spannungsgradienten gebildet und einem Ausgang zugeführt wird, daß zusätzlich zu den wenigstens zwei im Abstand voneinander angeordneten Spulensystemen ein weiteres, in einem Abstand von einem Vielfachen der halben Wellenlänge des periodisch schwingenden Bauteils (3) angeordnetes Spulensystem (11) vorhanden ist und daß die Meßwerte von zwei um diesen Abstand versetzten Spulensystemen (6, 11) verglichen werden.

2. Verfahren nach Anspruch 1, dadurch gekennzeichnet, daß das dem Leiter (1) abgewandte Spulensystem (11) einem System zur Erzeugung von Referenzfeldern ausgesetzt wird, und daß die Referenzfelder so gesteuert und verändert werden, bis ein Abgleich auf Null der Meßwerte der Spulensysteme (6, 11) erzielt wird.

3. Verfahren nach Anspruch 1, dadurch gekennzeichnet, daß der Erreger der mechanischen periodischen Schwingungen intermittierend betrieben wird und daß die Meßwerte der Spulensysteme (6, 11) in abgeschaltetem Zustand des Erregers einer Auswertung und Bearbeitung unterzogen werden.

## Claims

1. Method for contactlessly determining electrical measured quantities in a conductor (1), characterized in that at least two coil systems being arranged at a distance from one another are positioned in the electromagnetic field of the conductor (1), wherein an electrically conductive element (3) in the vicinity of the coils (6) is set into periodic mechanical oscillations, in that the signals of the coils (6), possibly after correction of their phases, are fed to a substraction circuit for determining a voltage gradient between these coils and in that in an evaluation circuit the quotient of the square value of a voltage measured value and the voltage gradient is formed and is fed to an output, in that in addition to the at least two coil systems being arranged at a distance from one another a further coil system (11) is provided at a distance of a multiple of half the wavelength of the periodically oscillating element (3) and in that the measured values from two coil systems (6, 11) being offset by this distance are compared.

2. Method according to claim 1, characterized in that the coil system (11) facing away from the conductor (1) is subjected to a system for the production of reference fields and in that the reference fields are controlled and varied, until the measured values of the coil systems (6, 11) reach a balance at zero.

3. Method according to claim 1, characterized in that the exciter of the mechanical periodic oscillations is operated intermittently and in that the measured values of the coil systems (6, 11) are subjected to an evaluation and processing with the exciter in the switched-off state.

## Revendications

1. Procédé de détermination sans contact de grandeurs mesurées électriques dans un conducteur (1), caractérisé par le fait qu'on met dans le champ électromagnétique du conducteur (1) au moins deux systèmes de bobines placés à une certaine distance l'un de l'autre et soumet un élément conducteur (3) à des vibrations mécaniques périodiques à proximité des bobines (6) de ces systèmes de bobines, qu'on envoie les signaux des bobines (6), éventuellement après une correction de leurs phases, à un circuit soustracteur pour la détermination d'un gradient de tension entre ces bobines et qu'on forme dans un circuit d'exploitation le quotient du carré d'une valeur mesurée de tension par le gradient de tension et l'envoie à une sortie, qu'en plus des deux ou plus de deux systèmes de bobines placés à distance l'un de l'autre existe un autre système de bobines (11) placé à une distance égale à un multiple de la moitié de la longueur d'onde de l'élément vibrant périodiquement (3), et qu'on compare les valeurs mesurées de deux systèmes de bobines (6, 11) écartés de cette distance.

2. Procédé selon la revendication 1, caractérisé par le fait qu'on expose le système de bobines (11) opposé au conducteur (1) à un système de production de champs de référence et qu'on commande et fait varier les champs de référence jusqu'à obtenir un alignement à zéro des valeurs mesurées des systèmes de bobines (6, 11).

3. Procédé selon la revendication 1, caractérisé par le fait qu'on actionne l'excitateur des vibrations mécaniques périodiques par intermittence et soumet les valeurs mesurées des systèmes de bobines (6, 11) à une exploitation et un traitement avec l'excitateur arrêté.
